Europäisches Patentamt

(19) European Patent Office

Office européen des brevets

(11) Numéro de publication: **0 141 114**
**B1**

## FASCICULE DE BREVET EUROPÉEN

(45) Date de publication du fascicule du brevet:
21.09.88

(21) Numéro de dépôt: **84110062.1**

(22) Date de dépôt: **23.08.84**

(51) Int. Cl.⁴: **G 05 D 9/12,** G 01 D 5/30,
G 01 F 23/28 //
C04B41/45

(54) Dispositif pour déposer en régime continu une couche de silicium polycristallin sur un ruban de carbone.

(30) Priorité: 29.08.83 FR 8313834
01.12.83 FR 8319212

(43) Date de publication de la demande:
15.05.85 Bulletin 85/20

(45) Mention de la délivrance du brevet:
21.09.88 Bulletin 88/38

(84) Etats contractants désignés:
AT BE CH DE FR GB IT LI LU NL SE

(56) Documents cité:
EP-A-0 048 688
FR-A-2 034 975
FR-A-2 323 645
FR-A-2 446 333
US-A-3 730 962
US-A-3 738 312
US-A-3 740 563
US-A-3 998 598
US-A-4 217 165
US-A-4 410 270

PATENTS ABSTRACTS OF JAPAN, vol. 3, no. 55(C-45), 11 mai 1979, page 69C45

(73) Titulaire: **COMPAGNIE GENERALE D'ELECTRICITE**
**Société anonyme dite:, 54, rue La Boétie, F-75382**
**Paris Cédex 08 (FR)**
Titulaire: **SOCIETE NATIONALE ELF AQUITAINE,**
**Tour Aquitaine - Cédex 4, F-92080 Paris la**
**Défense (FR)**

(72) Inventeur: **Mautref, Michel, 19, rue des Myosotis,**
**F-77330 Ozoir La Ferrière (FR)**
Inventeur: **Belouet, Christian, 138, rue Houdan,**
**F-92330 Sceaux (FR)**

(74) Mandataire: **Weinmiller, Jürgen, Lennéstrasse 9**
**Postfach 24, D-8133 Feldafing (DE)**

## Description

La présente invention concerne un dispositif pour déposer en régime continu une couche de silicium polycristallin sur un ruban de carbone, ce dispositif étant d'un type comportant

- un creuset,
- un système électrique pour alimenter le creuset en silicium,
- des moyens de chauffage du creuset pour former dans celui-ci un bain de silicium fondu
- et des moyens pour déplacer à vitesse constante de bas en haut le ruban de carbone traversant verticalement la surface d'équilibre du bain, afin de déposer ladite couche.

Un dispositif de ce type est connu par le document FR-A-2 386 359.

Les rubans de carbone revêtus de silicium obtenus à l'aide de ce dispositif peuvent être utilisés pour fabriquer des photopiles solaires. Il est important, pour les utilisateurs, d'obtenir une épaisseur constante du silicium déposé sur le ruban. Or, pour une vitesse de tirage donnée du ruban, il apparaît que cette épaisseur dépend de la température du bain de silicium fondu, cette température variant rapidement avec le niveau de la surface d'équilibre du bain. Pour avoir une épaisseur de silicium déposée constante, il est donc nécessaire de stabiliser le niveau du bain.

La présente invention a pour but de stabiliser, en fonction du temps, le niveau du bain de silicium fondu des dispositifs du type précité. Elle a aussi pour but de permettre le réglage, à une valeur constante prédéterminée, de l'épaisseur de la couche de silicium déposée à l'aide des dispositifs de ce type.

Ce but est atteint par le dispositif tel qu'il est défini dans la revendication 1.

Des formes particulières d'exécution de l'objet de la présente invention sont décrites ci-dessous, à titre d'exemple, en référence aux dessins annexés dans lesquels

- la figure 1 représente schématiquement un mode de réalisation du dispositif selon l'invention,
- la figure 2 est un schéma montrant avec plus de détails, illustré par la figure 1, le détecteur faisant le partie du dispositif
- et la figure 3 représente les surfaces photosensibles de deux cellules photoélectriques faisant partie du détecteur illustré par la figure 2.

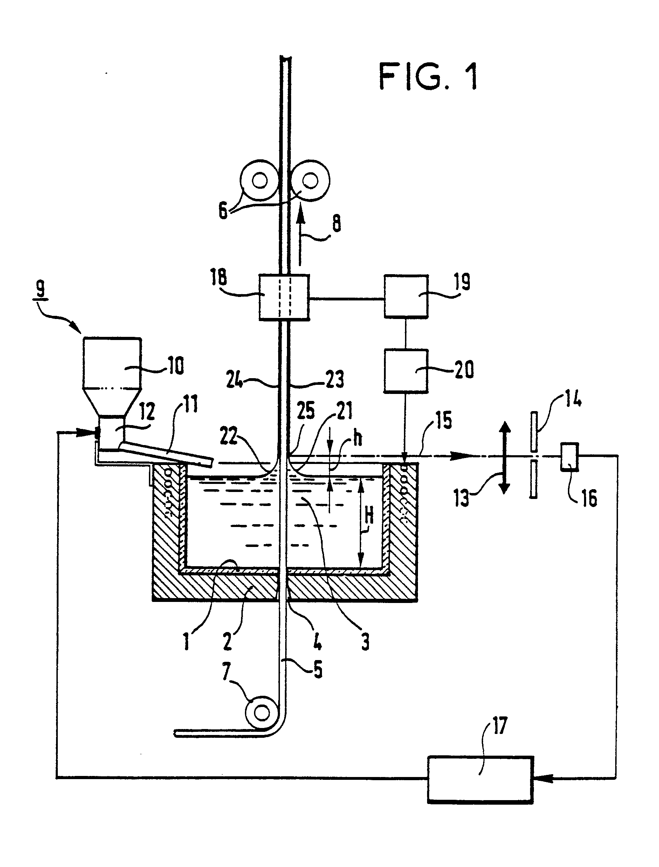

Sur la figure 1 est représenté un creuset 1 en silice, dont les parois extérieures sont entourées par un four 2 qui peut être du type à induction. Le creuset 1 contient un bain 3 de silicium fondu, dont la surface d'équilibre s'élève dans le creuset à un niveau H. Le fond du creuset 1 comporte une fente calibrée 4 à travers laquelle passe verticalement un ruban de carbone 5 qui traverse verticalement la surface d'équilibre du bain 3. Des rouleaux 6 et 7 permettent de déplacer le ruban 5 de bas en haut dans le sens de la flèche 8.

Un système électromécanique 9 est placé sur le bord du creuset 1 pour l'alimenter en silicium solide. Le système 9 comprend essentiellement un réservoir 10 de pastilles de silicium, un conduit 11 incliné vers l'intérieur du creuset et un organe électromécanique de distribution 12 reliant mécaniquement le réservoir 10 et le conduit 11.

Un système optique 13 schématisé par une simple lentille associée à un diaphragme 14, est centré sur un axe 15 fixe par rapport au creuset et situé un peu au-dessus du bain 3. Sur l'axe 15 est disposé un détecteur photoélectrique comprenant un assemblage 35 de deux cellules photoélectriques et un système de traitement 36 dont l'entrée est reliée aux sorties électriques des deux cellules. La sortie du système de traitement 36 est connectée, à travers un système d'asservissement 17, à la commande électrique de l'organe de distribution 12.

Un appareil de mesure d'épaisseur 18 entoure le ruban 5 à la sortie du bain 3. L'appareil 18 est relié, à travers un autre système d'asservissement 19 et un circuit de commande 20, à l'entrée électrique du four 2.

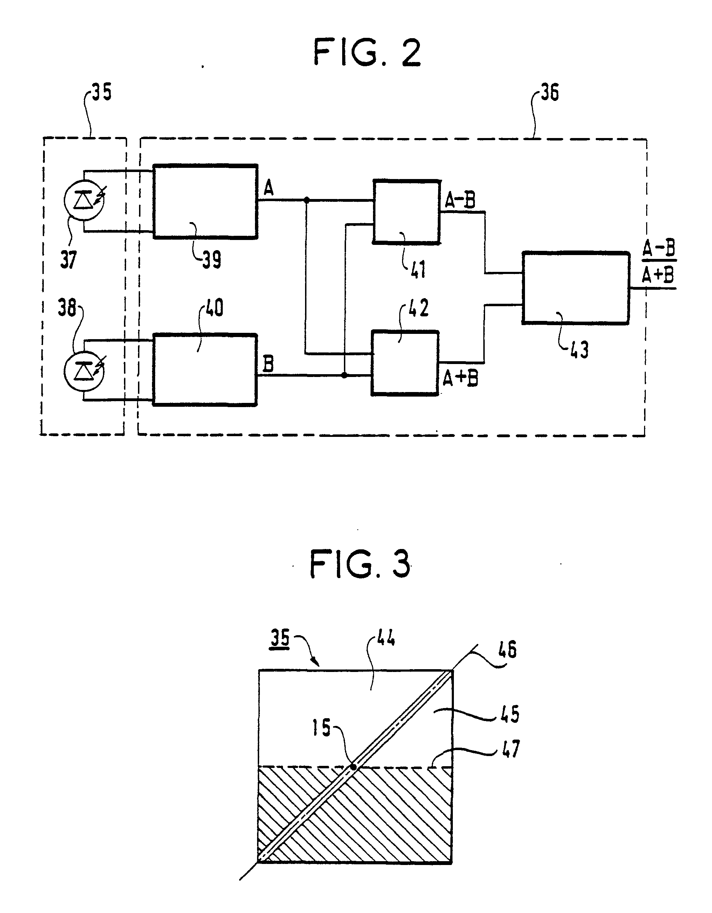

La figure 2 est un schéma du détecteur photoélectrique formé par l'assemblage 35 des deux cellules et par le système de traitement 36 connecté à cet assemblage. Ces cellules sont des photopiles 37 et 38. Les sorties électriques de la photopile 37 sont reliées à l'entrée d'un convertisseur courant-tension 39 ; de même les sorties électriques de la photopile 38 sont reliées à l'entrée d'un convertisseur 40 analogue au convertisseur 39, ces convertisseurs faisant partie du système 36. Les sorties des deux convertisseurs 39 et 40 sont reliées d'une part respectivement aux deux entrées d'un circuit soustracteur 41 et d'autre part aux deux entrées d'un circuit sommateur 42. Les sorties des circuits soustracteur et sommateur sont reliées respectivement aux deux entrées d'un circuit diviseur 43 dont la sortie constitue celle du système de traitement 36.

La figure 3 montre les surfaces photosensibles 44 et 45 des deux photopiles 37 et 38 formant l'assemblage 35. Les surfaces 44 et 45 sont en forme de triangle rectangle isocèle et sont juxtaposées dans un plan de part et d'autre d'une ligne de séparation 46 qui est parallèle au grand côté de chaque triangle et très proche de ces côtés. L'ensemble de ces deux cellules peut être obtenu en formant, par photogravure, une rainure étroite dans la zone de jonction d'une photopile solaire en forme de carré, cette rainure étant située selon la diagonale du carré.

Le dispositif représenté sur les figures fonctionne de la manière suivante.

Les moyens 6-7 de déplacement du ruban 5 étant en marche de façon à le faire circuler à vitesse constante dans le bain, on constate que le niveau d'équilibre du bain s'élève à proximité de chaque face du ruban pour former deux ménisques 21 et 22, tandis que deux couches 23 et 24 de silicium polycristallin se déposent sur les faces du ruban 5 à la sortie du bain 3. Entre le silicium liquide du bain 3 et le silicium solide de la couche 23, s'établit une ligne de raccordement 25, vue de bout sur la figure 1. Cette ligne est située à l'extrémité supérieure du ménisque 21, à une hauteur h au-dessus du niveau du bain. L'élévation de niveau h est due aux phénomènes de capillarité. Elle est pratiquement indépendante du niveau ainsi que de la température du bain et peut donc être considérée comme constante. Ainsi, la côte de la ligne de raccordement solide-liquide 25 est en relation directe avec le niveau du bain H.

Le dépôt des couches de silicium polycristallin sur le ruban de carbone entraîne une perte de matière pour le bain, cette perte tendant à faire baisser son niveau. Pour compenser cette perte de matière, le système d'alimentation 9 fait glisser sur le conduit 11 vers le bain des pastilles de silicium, une à une, à une cadence qui est commandée par le signal électrique fourni par le système d'asservissement 17 à l'organe électromécanique de distribution 12.

Le système optique 13-14 est fixé à proximité du creuset 1, de manière que son axe 15 coupe la ligne de raccordement 25 lorsque le bain est à un niveau H auquel on désire le stabiliser. La lentille 13 forme sur la surface de réception de l'assemblage 35 l'image d'une petite zone de la surface du silicium située de part et d'autre de la ligne de raccordement 25, cette zone étant délimitée par le diaphragme 14. L'axe 15 du système optique peut être horizontal comme représenté sur la figure 3, ou légèrement incliné par rapport à l'horizontale pour que le bord du creuset ne masque pas l'image de la petite zone.

Le plan des surfaces photosensibles 44 et 45 est perpendiculaire au plan de la figure 1 et le centre du carré formant la surface de réception de l'assemblage 35 est situé sur l'axe 15. Ce carré est orienté dans son plan de manière que l'image de la ligne de raccordement 25 sur la surface de réception coupe la ligne de séparation 46 suivant un angle différent de 90°, de préférence suivant un angle de 45 degrés, cet angle correspondant à la plus grande sensibilité du système. Sur la figure 3, cette image 47 passe par la trace de l'axe 15 sur la surface de réception puisque l'axe 15 coupe la ligne de raccordement 25 (figure 1).

En supposant que le système optique 13 comporte des moyens de redressement de l'image, la partie de la surface de réception située au dessous de la ligne 47 correspond au silicium liquide de la petite zone. Cette partie, hachurée sur la figure 3, est beaucoup moins éclairée que celle située au dessus de la ligne 47 car le silicium liquide a une luminosité beaucoup plus faible que celle du silicium solide au voisinage de sa température de fusion.

Lorsque le niveau du bain de silicium augmente ou diminue, l'image de la ligne de raccordement se déplace verticalement par rapport à la ligne 47 vers le haut ou vers le bas. Chaque cellule 37, 38 délivre un courant proportionnel au flux total qu'elle reçoit, ce courant étant transformé par le convertisseur branché à sa sortie en un signal de tension A, B. La surface de réception de l'assemblage 35 comprend deux plages, une première plage recevant le rayonnement du silicium liquide et une deuxième plage éclairée par le silicium solide avec une puissance P, le contraste entre l'éclairement de ces deux plages étant de l'ordre de 1/20. On peut donc admettre que, pour chaque cellule, le courant délivré correspondant à la première plage est négligeable par rapport à celui correspondant à la deuxième plage. Chaque signal A ou B est donc sensiblement proportionnel à P et à l'aire de la deuxième plage de la cellule. Il apparait alors que le signal de sortie du circuit de traitement 36, qui est égal à $\frac{A-B}{A+B}$, est représentatif du niveau de la ligne de raccordement et donc du niveau du bain de silicium fondu puisque la valeur de h est constante. Le système d'asservissement 17 compare le signal électrique délivré par le circuit de traitement 36 à un signal de référence pour former un signal d'erreur, et commande la cadence de distribution des pastilles de silicium de façon à diminuer ce signal d'erreur. Le dispositif illustré par la figure 1 permet donc de stabiliser le niveau du bain à une valeur prédéterminée.

L'épaisseur de la couche de silicium polycristallin déposée sur le ruban 5 varie avec la température du bain, de quelques micromètres par degré C environ. De plus, la température du bain varie en fonction du niveau du bain, sensiblement de 3 degrés C par millimètre. Le dispositif décrit ci-dessus permet d'éviter les variations de température du bain provoquées par les fluctuations de son niveau. Donc, si l'on fait varier la température du bain en agissant sur la chaleur dégagée par le four 2, on peut régler l'épaisseur de la couche de silicium déposée sur le ruban de carbone.

Pour cela, l'appareil de mesure 18 qui peut être par exemple une sonde à rayons X ou à rayons gamma, une sonde capacitive, ou un système différentiel de palpeurs mécaniques, délivre un signal électrique de mesure représentatif de l'épaisseur de la couche de silicium déposée. Le système d'asservissement 19 compare ce signal à un signal de référence et commande par l'intermédiaire du circuit 20 la puissance délivrée par le four 2 de façon à diminuer la différence entre le signal de mesure et le signal de référence. Le système d'asservissement 19 peut comporter des moyens pour faire varier le signal de référence, de façon à commander une variation correspondante de l'épaisseur de silicium déposée.

Le signal électrique de sortie du système de traitement 36 est indépendant de la puissance P du rayonnement du silicium, et donc indépendant des variations de cette puissance P en fonction du temps. Il apparait en effet que la puissance P peut varier dans le temps, soit par suite de variations de température du silicium, soit par suite de variations de l'homogénéité du silicium, soit par suite de variations du lobe d'émission lumineuse du silicium provoquées par une déformation du ruban de carbone. Le dispositif selon l'invention permet donc d'effectuer la régulation du niveau du bain de silicium fondu sans être géné par les variations de la puissance lumineuse P.

Le dispositif décrit ci-dessus peut être appliqué à la fabrication en série de photopiles solaires.

**Revendications**

1. Dispositif pour déposer en régime continu une couche de silicium polycristallin sur un ruban de carbone (5), comportant
- un creuset (1),
- un système électro-mécanique (9) pour alimenter le creuset en silicium,
- des moyens de chauffage (2) du creuset pour former dans celui-ci un bain de silicium fondu
- et des moyens (6-8) pour déplacer à vitesse constante de bas en haut le ruban de carbone traversant verticalement la surface d'équilibre du bain, afin de déposer ladite couche, caractérisé en ce qu'il comporte en outre
- un système optique (13, 14) centré sur un axe (15) fixe par rapport au creuset (1), ce système étant disposé pour former une image d'une zone de la surface de silicium, cette zone étant située de part et d'autre de la ligne de raccordement (25) entre le silicium liquide et le silicium solide déposé sur le ruban (5),
- deux cellules photoélectriques (37, 38) dont les surfaces photosensibles (44, 45) sont coplanaires et juxtaposées de part et d'autre d'une ligne de séparation (46), et qui sont disposées de façon que la ligne de séparation (46) coupe l'image de ladite ligne de raccordement (25) et fasse avec elle un angle différent de 90°,
- un système de traitement (36) branché à la sortie des cellules (37, 38), ce système comprenant des moyens pour faire la somme (42) et la différence (41) des signaux de sortie des deux cellules (37, 38) et des moyens (43) pour faire le quotient de cette différence par cette somme, ces derniers moyens étant aptes à délivrer un signal électrique représentatif du niveau du bain (3) dans le creuset (1), ce signal étant indépendant des variations dans le temps de la puissance lumineuse émise par ladite zone,
- et un systeme d'asservissement (17) recevant ledit signal électrique et capable de comparer ce signal à un signal de référence représentatif d'un niveau prédéterminé (H) du bain (3) pour former un signal d'erreur, le système d'asservissement (17) étant relié au système électrique (9) pour alimenter le creuset (1) en silicium, afin de commander l'alimentation du creuset de façon à réduire ledit signal d'erreur.

2. Dispositif selon la revendication 1, caractérisé en ce qu'il comporte en outre
- un appareil (18) de mesure de l'épaisseur de la couche (23) de silicium déposé sur le ruban (5) de carbone
- et un autre système d'asservissement (19) relié à l'appareil de mesure et capable de déterminer la différence entre l'épaisseur mesurée et une épaisseur de référence prédéterminée, cet autre système d'asservissement (19) étant relié auxdits moyens de chauffage (2) du creuset (1) pour régler le chauffage de façon à réduire ladite différence.

3. Dispositif selon la revendication 1, caractérisé en ce que ledit système optique comporte un diaphragme (14) pour délimiter ladite zone.

4. Dispositif selon la revendication 1, caractérisé en ce que ledit système de traitement (36) comporte deux convertisseurs courant-tension (39, 40) connectés respectivement à la sortie des deux cellules (37, 38), un circuit sommateur (42) et un circuit soustracteur (41), chacun de ces circuits comprenant deux entrées connectées respectivement aux sorties des deux convertisseurs (39, 40), et un circuit diviseur (43) dont les deux entrées sont connectées respectivement à la sortie du circuit sommateur (42) et à la sortie du circuit soustracteur (41).

5. Dispositif selon la revendication 1, caractérisé en ce que l'angle que font entre elles l'image (47) de la ligne de raccordement (25) et la ligne de séparation (46) est égal à 45°.

6. Dispositif selon la revendication 1, caractérisé en ce que les surfaces photosensibles (44, 45) des deux cellules photoélectriques (37, 38) sont constituées par la surface photosensible d'une photopile solaire, cette surface étant divisée en deux parties (44, 45) par une rainure disposée selon ladite ligne de séparation (46).

**Patentansprüche**

1. Vorrichtung zur kontinuierlichen Abscheidung einer polykristallinen Siliziumschicht auf einem Kohlentoffband (5) ,
- mit einem Schmelztiegel (1),
- mit einem elektromechanischen System (9) zur Einspeisung von Silizium in den Tiegel,
- mit Heizmitteln (2) für den Tiegel zur Bildung eines Bades geschmolzenen Siliziums,
- und mit Mitteln (6-8) zum Ziehen des Kohlenstoffbandes von unten nach oben mit konstanter Geschwindigkeit senkrecht durch die Badoberfläche, zur Abscheidung der Schicht, dadurch gekenzeichnet, daß sie weiter umfaßt
- ein optisches System (13, 14), welches auf eine bezüglich des Tiegels (1) feste Achse (15) zentriert ist und zur Erzeugung eines Bildes einer Oberflächenzone des Siliziums fähig ist, wobei die Zone zu beiden Seiten der Verbindungslinie (25) zwischen dem flüssigen und dem festen auf dem Band (25) abgeschiedenen Silizium liegt,
- zwei lichtelektrischen Zellen (37, 38), deren lichtempfindliche Oberflächen (44, 45) koplanar ausgebildet und zu beiden Seiten einer Trennlinie (46) und derart angeordnet sind, daß die Trennlinie (46) das Bild der Verbindungslinie (25) schneidet und mit ihr einen von 90° verschiedenen Winkel bildet,

- ein Verarbeitungssystem (36), welches an den Ausgang der Zellen (37, 38) angeschlossen ist und Mittel zur Bildung der Summe (42) und der Differenz (41) der Ausgangssignale der beiden Zellen (37, 38) sowie Mittel (43) zur Bildung des Quotienten aus dieser Differenz und dieser Summe aufweist, wobei die letztgenannten Mittel ein elektrisches Signal zu liefern in der Lage sind, das den Pegel des Bades (3) im Tiegel (1) repräsentiert und unabhängig von den zeitlichen Änderungen der von der genannten Zone ausgesandten Lichtleistung ist,

- und ein Servosystem (17), welches das elektrische Signal empfängt und in der Lage ist, das Signal mit einem für einen vorbestimmten Pegel (H) des Bades (3) repräsentativen Bezugssignal zu vergleichen, um ein Fehlersignal zu erzeugen, wobei das Servosystem (17) mit einem elektrischen System (9) zur Versorgung des Tiegels (1) mit Silizium verbunden ist, um die Einspeisung in den Tiegel so zu steuern, daß das Fehlersignal sich verkleinert.

2. Vorrichtung nach Anspruch 1, dadurch gekennzeichnet, daß es weiter aufweist:

- ein Gerät zur Dickenmessung der Schicht (23) des abgeschiedenen Siliziums auf dem Kohlenstoffband (5),

- und ein weiteres Servosystem (19), das mit dem Dickenmeßgerät verbunden und in der Lage ist, die Differenz zwischen der gemessenen Dicke und einer vorbestimmten Bezugsdicke zu bestimmen, wobei dieses Servosystem (19) mit den Heizmitteln (2) für den Tiegel (1) zur Regulierung der Heizung so verbunden ist, daß die Differenz sich verkleinert.

3. Vorrichtung nach Anspruch 1, dadurch gekennzeichnet, daß das optische System eine Blende (14) zur Begrenzung der Zone aufweist.

4. Vorrichtung nach Anspruch 1, dadurch gekennzeichnet, daß das Verarbeitungssystem (36) zwei Strom-Spannungs-Wandler (39, 40), die je an den Ausgang einer der beiden Zellen (37, 38) angeschlossen sind, einen Summierkreis (42) und einen Subtrahierkreis (41), wobei jeder dieser beiden Kreise zwei jeweils mit den Ausgängen der beiden Wandler (39, 40) verbundene Eingänge aufweist, und einen Dividierkreis (43) aufweist, dessen beide Eingänge mit dem Ausgang des Summierkreises (42) bzw. dem Ausgang des Subtrahierkreises (41) verbunden sind.

5. Vorrichtung nach Anspruch 1, dadurch gekennzeichnet, daß der Winkel, den das Bild (47) der Verbindungslinie (25) mit der Trennlinie (46) einschließt, gleich 45° ist.

6. Vorrichtung nach Anspruch 1, dadurch gekennzeichnet, daß die lichtempfindlichen Oberflächen (44, 45) der beiden lichtelektrischen Zellen (37, 38) aus der lichtempfindlichen Oberfläche einer Solarzelle bestehen, wobei die Oberfläche durch eine Rille entlang der Teilungslinie (46) in zwei Abschnitte (44, 45) unterteilt ist.

## Claims

1. A device for a continuous process deposition of a polycristalline silicon layer on a carbon tape (5), comprising:
- a crucible (1),
- an electromechanical system (9) for feeding silicon to the crucible,
- crucible heating means (2) for preparing a bath of molten silicon in it,
- and means (6 to 8) for displacing the carbon tape from bottom to top while traversing vertically the equilibrium surface of the bath, in order to deposit said layer, characterized in that it further comprises:
- an optical system (13, 14) centred on an axis (15) stationary in relation to the crucible (1), the system being arranged to form an image of a zone of the silicon surface, this zone extending on both sides of the connection line (25) between the liquid silicon and the solid silicon deposited on the carbon tape,
- two photoelectric cells (37, 38), the photosensitive surfaces (44, 45) of which are coplanar and extend in juxtaposition, on both sides of a separation line (46), and which are disposed such that the separation line (46) intersects the image of the connection line (25) at an angle which is different from 90°,
- a processing system (36) connected to the output of the cells (37, 38) and comprising means for generating the sum (42) and the difference (41) of the output signals of the two cells (37, 38), and means (43) for generating the quotient of the difference by that sum, wherein the latter means are adapted to deliver an electrical signal representing the level of the bath (3) in the crucible (1), this signal being independent of the variations in time of the light power generated by said zone,
- and a servo-system (17) receiving said electrical signal and being adapted to compare the signal with a reference signal representing a predetermined level (H) of the bath (3) yielding an error signal, the servo-system (17) being connected to the electrical system (9) charged with feeding the crucible (1) with silicon, in order to control the feeding ot the crucible in such a way as to reduce the error signal.

2. A device according to claim 1, characterized in that it further comprises
- an apparatus (18) for measuring the thickness of the silicon layer (23) deposited on the carbon tape (5),
- and another servo system (19) connected to the measuring apparatus and adapted to determine the difference between the measured thickness and a predetermined reference thickness, said other servo-system (19) being connected to the heating means (2) of the crucible (1) in order to control the heating in such a way as to reduce said difference.

3. A device according to claim 1, characterized in that the optical system includes a diaphragm (14) for delimiting said zone.

4. A device according to claim 1, characterized in that the processing system (36) comprises two current-to-voltage converters (39, 40) respectively connected to the output of the two cells (37 38), a summing circuit (42) and a subtracting circuit (41), each of the circuits comprising two inputs connected respectively to the outputs of the two converters (39, 40), as well as a dividing circuit (42), the two inputs of which being respectively connected to the output of the summing circuit (42) and to the output of the subtracting circuit (41).

5. A device according to claim 1, characterized in that the angle comprised between the image (47) of the connection line (25) and the separation line (46) is equal to 45°.

6. A device according to claim 1, characterized in that the photosensitive surface (44, 45) of the two photoelectric cells (37, 38) consist of the photosensitive surfaces of a photosensitive solar battery, subdivided into two portions by a groove disposed along said separation line (46).

FIG. 1

# FIG. 2

# FIG. 3